# EUROPÄISCHE PATENTSCHRIFT

(11) **EP 1 524 768 B1**
(45) Veröffentlichungstag und Bekanntmachung des Hinweises auf die Patenterteilung: **19.04.2006**
(21) Anmeldenummer: 05000762.4
(22) Anmeldetag: 06.07.1998
(51) Int. Cl.: H03K 17/732, H03K 17/723

(54) **Ansteuerschaltung zum Ein- und Ausschalten eines Abschaltthyristors**
Method and device for controlling a gate turn-off thyristor
Procédé et dispositif servant à commander un thyristor blocable

(30) Priorität: 24.07.1997 DE 19731836
(43) Veröffentlichungstag der Anmeldung: 20.04.2005
(62) Teilanmeldung aus: 98810627.4
(73) Patentinhaber: ABB Schweiz AG, 5400 Baden (CH)
(72) Erfinder: Grüning, Horst, 5430 Wettingen (CH); Coenraads, Ard, 3514 V6 Utrecht (NL)
(74) Vertreter: ABB Patent Attorneys

(56) Entgegenhaltungen:
- EP-A- 0 416 933
- WO-A-94/07309
- DE-A- 3 446 344
- DE-A- 3 714 683
- US-A- 4 297 594
- US-A- 4 593 204
- PATENT ABSTRACTS OF JAPAN Bd. 002, Nr. 097 (E-049), 15. August 1978 (1978-08-15) -& JP 53 062974 A (TOSHIBA CORP), 5. Juni 1978 (1978-06-05)
- SZILAGYI P ET AL: "Further refinements to an optimum gate drive for high power GTO thyristors" POWER CONVERSION CONFERENCE, 1993. YOKOHAMA 1993., CONFERENCE RECORD OF THE YOKOHAMA, JAPAN 19-21 APRIL 1993, NEW YORK, NY, USA,IEEE, US, 19. April 1993 (1993-04-19), Seiten 44-48, XP010056594 ISBN: 0-7803-0471-3
- KOJORI H A ET AL: "AN OPTIMUM GATE DRIVE FOR HIGH POWER GTO THYRISTORS" PROCEEDINGS OF THE ANNUAL APPLIED POWER ELECTRONICS CONFERENCE AND EXHIBITION. (APEC),US,NEW YORK, IEEE, Bd. CONF. 7, 1992, Seiten 439-444, XP000340810

## Beschreibung

### Technisches Gebiet

Die Erfindung bezieht sich auf das Gebiet der Leistungselektronik. Sie geht aus von Ansteuerschaltung zum Ein- und Ausschalten eines Abschaltthyristors gemäss dem Oberbegriff des unabhängigen Anspruchs.

### Stand der Technik

Eine gattungsgemässe Ansteuerschaltung ist aus der Europäischen Patentanmeldung EP 0 489 945 A1 bekannt. Beschrieben wird die sogenannte harte Ansteuerung eines Abschaltthyristors, bei der im Gegensatz zur kowentionellen Ansteuerung ein höherer und sehr viel steilerer Strom zum Ausschalten des Abschaltthyristors (GTO) an das Gate angelegt wird. Ausserdem sind Mittel zum Erzeugen eines Einschaltstromes vorgesehen. Diese Mittel erzeugen einen Strom zum Einschalten des Abschaltthyristors und einen Haltestrom zum Aufrechterhalten des eingeschalteten Zustandes. Die Mittel umfassen jeweils Kondensatoren, in denen die notwendige Energie gespeichert wird und mit Hilfe von Schaltern bedarfsweise entnommen wird.

Aus der DE 197 08 873 A1 ist ferner eine räumliche Anordnung für eine gattungsgemässe Ansteuereinheit bekannt. Um die harte Ansteuerung zu realisieren, sind nämlich Anordnungen mit sehr niederinduktivem Aufbau gefragt. Zu diesem Zweck wird in der DE 197 08 873 A1 vorgeschlagen, die Bauelemente in unmittelbarer Nähe des Abschaltthyristors anzuordnen.

Ferner offenbart die DE 3 446 344 A1 eine Ansteuerschaltung zum Ein- und Ausschalten eines Abschaltthyristors, die eine Ausschaltschaltung und eine Einschaltschaltung umfasst. Die Ausschaltschaltung umfasst einen kapazitiven Energiespeicher, welcher an den Kathodenanschluss und über einen ersten Schalter an den Gateanschluss des Abschaltthyristors angeschlossen ist. Weiterhin umfasst die Einschaltschaltung einen elektrischen Energiespeicher. Die Einschaltschaltung weist ferner einen zweiten Schalter auf, wobei zudem für die Einschaltschaltung und für die Ausschaltschaltung Transformatoren vorgesehen sind.

Weiterhin offenbart die DE 37 14 683 A1, die EP 0 416 933 A2, die US 4,297,594 sowie die JP 53-62974 jeweils eine Ansteuerschaltung zum Ein- und Ausschalten eines Abschaltthyristors nach dem bisherigen Stand der Technik.

Ganz allgemein wäre es aber wünschenswert, eine Ansteuerschaltung zu haben, die mit möglichst geringem schaltungstechnischen, vor allem ohne Transformatoren, und energetischem Aufwand auskommt, um den Aufbau eines kompakten Stromrichters zu ermöglichen.

### Darstellung der Erfindung

Aufgabe der Erfindung ist es deshalb, eine Ansteuerschaltung zum Ein- und Ausschalten eines Abschaltthyristors anzugeben, die mit kleinstem Platzbedarf, vor allem ohne Transformatoren, und Energiebedarf auskommt und insbesondere für die Anwendung des harten Ansteuerverfahrens geeignet ist. Diese Aufgabe wird durch die Merkmale des Anspruchs 1 gelöst. In den abhängigen Ansprüchen sind vorteilhafte Weiterbildungen der Erfindung angegeben.

Die erfindungsgemässe Ansteuerschaltung zum Ein- und Ausschalten eines Abschaltthyristors umfasst eine Ausschaltschaltung und eine Einschaltschaltung, wobei die Ausschaltschaltung einen kapazitiven Energiespeicher aufweist, welcher an den Kathodenanschluss und über einen ersten Schalter an den Gateanschluss des Abschaltthyristors angeschlossen ist und aus dem mittels des ersten Schalters Energie zur Erzeugung eines Ausschaltstromes entnehmbar ist. Die Einschaltschaltung ist zum Erzeugen eines Einschaltstromes und eines einen eingeschalteten Zustand des Abschaltthyristors aufrechterhaltenden Haltestromes ausgebildet, wobei die Einschaltschaltung einen elektrischen Energiespeicher umfasst, der Spannungspulse in den Einschaltstrom und den Haltestrom umwandelt. Es können ein gemeinsamer elektrischer Energiespeicher für den Einschaltstrom und für den Haltestrom oder auch getrennte elektrische Energiespeicher vorgesehen sein. Ferner weist die Einschaltschaltung einen zweiten Schalter auf. Erfindungsgemäss umfasst die Einschaltschaltung eine Speicherinduktivität, mittels welcher zur Erzeugung des Haltestromes dem kapazitiven Energiespeicher Spannungspulse entnehmbar und dem elektrischen Energiespeicher der Einschaltschaltung zuführbar sind, wobei die Einschaltschaltung zur Erzeugung des Einschaltstromes eine zuschaltbare Zündinduktivität umfasst. Durch diese Massnahmen ist eine Ansteuerschaltung zum Ein- und Ausschalten eines Abschaltthyristors mit wenig Bauteilen und mit kleinstem Platzbedarf, vor allem ohne Transformatoren, sowie mit geringem Energiebedarf realisierbar und insbesondere für die Anwendung des harten Ansteuerverfahrens geeignet. Zudem wird zur Erzeugung des Einschaltstromes bzw. des Zündstromes des Abschaltthyristors vorteilhaft die Ausschaltschaltung zu Hilfe genommen. Allgemein kann der schaltungstechnische Aufwand mit der erfindungsgemässen Ansteuerschaltung äusserst gering gehalten werden. Der Wirkungsgrad der Ansteuerschaltung ist sehr hoch. Somit ist es möglich, die Ansteuerschaltung sehr nahe beim Abschaltthyristor anzuordnen und die Induktivität wie gewünscht gering zu halten.

Schaltungstechnisch ist es insbesondere von Vorteil, wenn die benötigten Spannungspulse derselben Energiequelle, bzw. demselben Energiespeicher entnommen werden, wie der für die Erzeugung des Ausschaltstromes benötigte Puls. Der Haltestrom wird vorzugsweise durch Wiederholen von Spannungspulsen erzeugt. Die Wiederholfrequenz dieser Spannungspulse kann dann je nach Bedarf erhöht oder verringert werden. Insbesondere wenn die Gate- Kathodenspannung negativ wird, wird die Frequenz reduziert, um bei erneut positiver Spannung wieder erhöht zu werden. Die Übertragung der benötigten Energie aus dem Energiespeicher der Ausschaltschaltung auf die Energiespeicher der Einschaitschaltung kann entweder mittels induktiver Kopplung oder mittels kapazitiver Kopplung erfolgen. Besonders bevorzugt wird eine Ansteuerschaltung, bei der die elektrische Speisung der benötigten Logikschaltungen und der anderen Bauteile auf dem erwähnten Energiespeicher der Ausschaltschaltung basiert.

Diese und weitere Aufgaben, Vorteile und Merkmale der vorliegenden Erfindung werden aus der nachfolgenden detaillierten Beschreibung der bevorzugten Ausführungsform der Erfindung in Verbindung mit der Zeichnung offensichtlich.

### Kurze Beschreibung der Zeichnungen

Es zeigen:
- Fig. 1: Ein Schaltbild eines ersten Beispiels einer Ansteuerschaltung zum Ein- und Ausschalten eines Abschaltthyristors,
- Fig. 2: ein Schaltbild eines zweiten Beispiels der Ansteuerschaltung,
- Fig. 3: ein Schaltbild eines dritten Beispiels der Ansteuerschaltung,
- Fig.4: ein Schaltbild eines vierten Beispiels der Ansteuerschaltung,
- Fig. 5: eine schematische Darstellung des Spannungspulses und des dadurch erzeugten Stromes und
- Fig. 6: ein Schaltbild einer Ausführungsform der Ansteuerschaltung nach der Erfindung.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

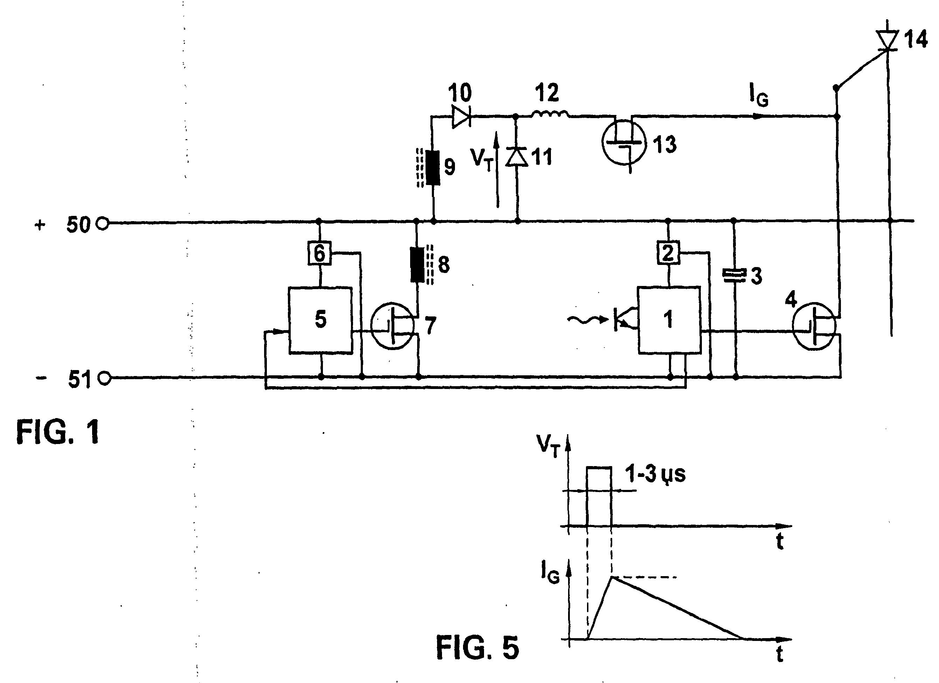

Fig. 1 zeigt ein Schaltbild einer Ansteuerschaltung für einen Abschaltthyristor 14. Mit 50 und 51 sind die Plus- und Minusanschlüsse einer Spannungsquelle mit z.B. 20 V Ausgangsspannung bezeichnet. Von dieser Spannungsquelle wird ein zu einer Ausschaltschaltung gehörender Energiespeicher 3 gespeist. Der Energiespeicher 3 kann insbesondere in Form einer Elektrolytkondensatorbank ausgebildet sein. Die Ansteuerschaltung umfasst neben der Ausschaltschaltung auch eine Einschaltschaltung. Die Ausschaltschaltung wird im wesentlichen gebildet durch eine Ausschaltlogik 1, durch den Energiespeicher 3 und einen ersten Schalter 4. Der ersten Schalter 4 ist an das Gate des Abschaltthyristors 14 und an den Energiespeicher 3 angeschlossen und wird von der Ausschaltlogik 1 angesteuert. Die Ausschaltlogik 1 wird vorzugsweise von einem Längsregler 2 (ein handelsüblicher Spannungsregler) gespeist. Die benötigten Steuersignale empfängt die Ausschaltlogik 1 beispielsweise über einen Lichtwellenleiter, angedeutet durch den Pfeil und den Transistor am linken Rand des Blockes der Ausschaltlogik 1. Ein über den Lichtwellenleiter gesandter Befehl, den Abschaltthyristor 14 auszuschalten, wird in der Logik 1 verstärkt und bildet eine Spannung an dem ersten Schalter 4, so dass dieser zu leiten beginnt. Aufgrund der Polarität des Energiespeichers 3 wird somit ein Strom aus dem Gate des Abschaltthyristors 14 gezogen. Dadurch wird das Gate des Abschaltthyristors gegenüber der Kathode negativ, und der Abschaltthyristor schaltet aus. Der erste Schalter 4 kann insbesondere auch eine Parallelschaltung von MOSFETs umfassen. Analoges gilt für den Energiespeicher 3, der aus einer Mehrzahl von parallel geschalteten ELKOs bestehen kann.

Ausserdem ist eine Einschaltschaltung vorgesehen. Diese umfasst eine Einschaltlogik 5, die in gleicher Weise wie die Ausschaltlogik 1 von dem Energiespeicher 3 gespeist wird. Der entsprechende Längsregler ist mit 6 bezeichnet. Die beiden Logiken 1 und 5 sind signalmässig miteinander verbunden. Empfängt die Ausschaltlogik 1 einen Befehl zum Ausschalten des Abschaltthyristors 14, so wird auf diese Weise eine Aktivierung der Einschaltlogik 5 unterbunden. Empfängt die Logik 1 jedoch einen Einschaltbefehl, so zwingt die Einschaltlogik 5 den von ihr angesteuerten zweiten Schalter 7 zum Takten. Der zweite Schalter 7 ist ebenfalls zwischen den Anschlüssen 50 und 51 angeordnet. Die auf diese Weise erzeugten Spannungspulse werden mit Hilfe des zum zweiten Schalter 7 in Serie geschalteten Transformators 8, 9 zu einer Gleichrichterdiode 10 übertragen, die einen elektrischen Energiespeicher 12, vorzugsweise eine Speicherinduktivität 12 speist. Die Induktivität des Transformators 8,9 sollte, um die ganze Anordnung wie gewünscht niederinduktiv zu halten, kleiner sein, als die Speicherinduktivität 12. Dies kann baulich beispielsweise dadurch erreicht werden, dass die Spulen 8 und 9 des Transformators, auf der Platine integriert und mit einem Kern magnetisch gekoppelt werden. Je nach geforderter Grösse der Speicherinduktivität 12 kann auch sie als Leiterschleife auf der Platine integriert werden. Die Speicherinduktivität 12 ist über einen dritten Schalter 13 mit dem Gate des Abschaltthyristors 14 verbunden. Der dritte Schalter 13 trennt die Einschaltschaltung beim Ausschalten und im ausgeschalteten Zustand von dem Gate des Abschaltthyristors 14.

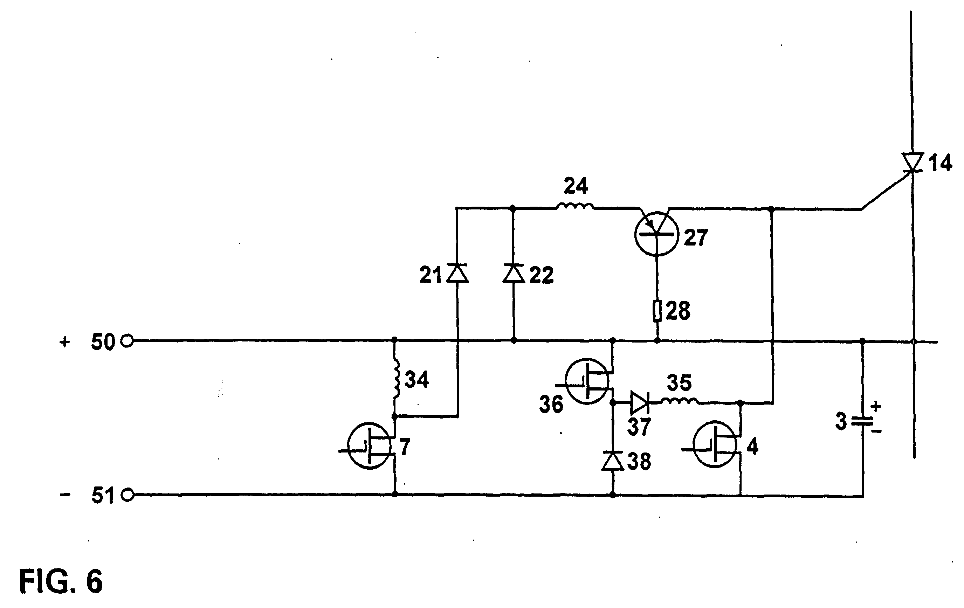

Fig. 5 zeigt einen solchen Spannungspuls V_{T}, der über den Transformator 8, 9 übertragen wird. Sekundärseitig wird der Spannungspuls durch die Gleichrichterdiode 10 gleichgerichtet und in der Speicherinduktivität 12 in einen Strom umgewandelt. Über die zwischen Plusanschluss 50 und Kathode angeordnete Freilaufdiode 11 kann der Strom umschwingen. Der Strom durch die Speicherinduktivität 12 hat in erster Näherung eine Dreiecksform wie in Fig. 5 dargestellt. Für einen 3kA, 4.5kV Abschaltthyristor werden zum Einschalten ca. 200A bis 400A benötigt, die während ca. 5µs bis 15µs aufrecht erhalten werden sollten. Daraus ergeben sich beispielhafte Werte für die Speicherinduktivität 12 im Bereich von 100nH. Nach dem Einschalten benötigt der Abschaltthyristor 14 aber noch einen gewissen Haltestrom, um den eingeschalteten Zustand aufrecht zu erhalten. Am einfachsten kann dies dadurch erfolgen, dass der beschriebene Einschaltpuls mit einer bestimmten Frequenz f1 wiederholt wird.

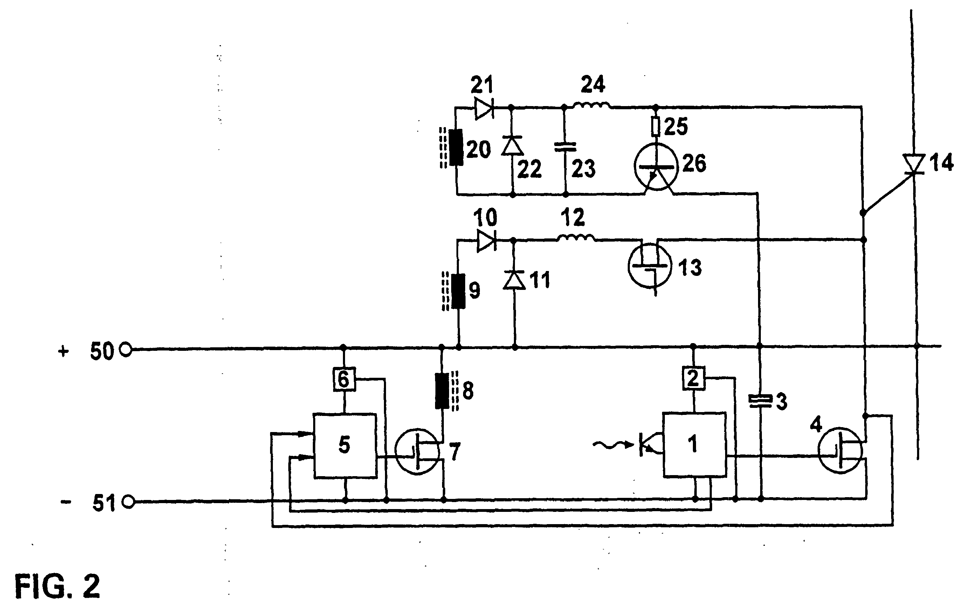

Der Strombedarf zum Zünden einerseits und zum Aufrechterhalten des gezündeten Zustandes andererseits ist sehr unterschiedlich. Zum Zünden sind für Abschaltthyristoren höchster Leistung wie erwähnt ca. 200A notwendig, während der Haltestrom lediglich ca. 2 A betragen muss. Aus diesem Grund wäre es vorteilhaft, wenn der Haltestrom mit weniger Leistung erzeugt werden könnte als durch Wiederholen des Einschaltpulses. Fig. 2 zeigt ein Ausführungsbeispiel, das diesem Erfordernis gerecht wird. Es ist eine zweite Induktivität 24 vorgesehen, die ebenfalls über den Transformator 8, 9 via eine zweite Sekundärwicklung 20 gespeist wird. Die Gleichrichterdiode trägt die Bezugsziffer 21, die Freilaufdiode 22. Vorzugsweise ist parallel zu der Freilaufdiode 22 eine Kapazität 23 geschaltet. Die Kapazität 23 ermöglicht eine langsamere Energieaufnahme, so dass die Wiederholfrequenz kleiner gehalten werden kann und der Haltestrom dennoch ausreichend gleichmässig ist. Dadurch kann die zweite Induktivität 24 grösser gewählt werden als die Speicherinduktivität 12, z. B. im Bereich von 10µH bis 50µH. Anstelle einer zweiten Sekundärwicklung 20 kann auch ein eigener Transformator und eine eigene Logik vorgesehen sein. Bei dieser von der Erzeugung des Einschaltpulses getrennten Erzeugung des Haltestromes wird der dritte Schalter 13 nach dem Zünden des Abschaltthyristors 14 geöffnet, so dass die Speicherinduktivität 12 vom Gate getrennt ist.

Im Falle der getrennten Erzeugung des Haltestromes sind zwischen das Gate und die Kathode des Abschaltthyristors 14 aktive Stromanstiegsbegrenzungsmittel 25, 26 geschaltet. Die Mittel 25, 26 umfassen zur Begrenzung des Haltestromes einen Transistor 26, der im Falle der Figur 2 in den Strompfad zwischen Einschaltschaltung und Kathode geschaltet ist. Bevorzugt wird eine Schaltung mit einem Bipolartransistor 26 und einem Basisvorwiderstand 25. Diese Mittel 25, 26 verhindern zuverlässig, dass der Haltestrom bei einer negativen Gate-Kathoden-Spannung ungehindert ansteigen kann. Bei einer negativen Spannung wird die Freilaufdiode 22 nämlich leitend, und damit könnte der Strom ungehindert ansteigen. Dies wird durch die Vorrichtung wirksam verhindert.

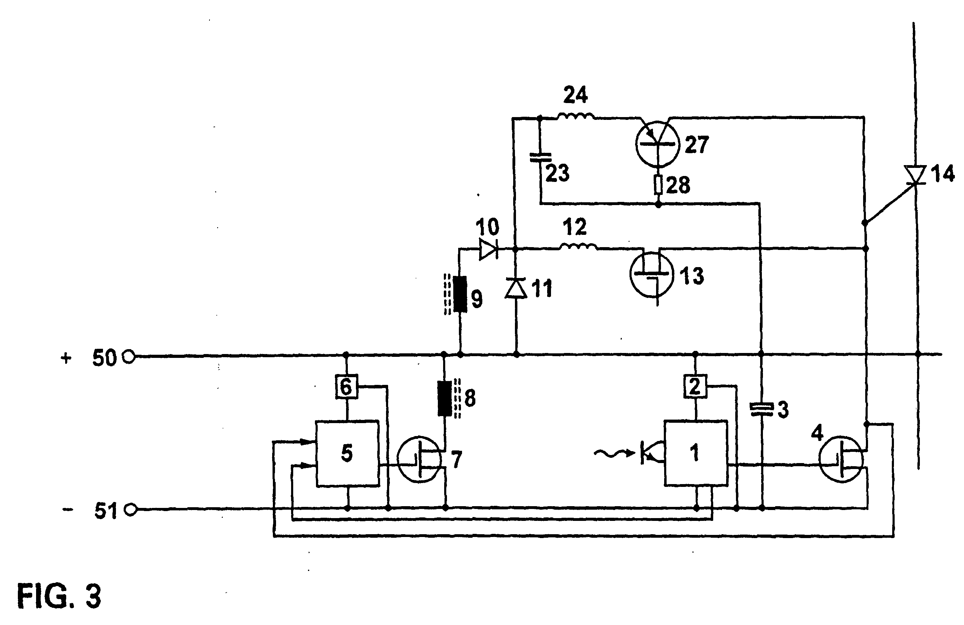

Der für die Erzeugung des Haltestromes benötigte Spannungspuls kann auch ohne eine zweite Sekundärwicklung direkt an der gleichgerichteten Spannung nach der Gleichrichterdiode 10 abgegriffen werden. Fig. 3 zeigt ein entsprechendes Ausführungsbeispiel. Der gemeinsame Knotenpunkt der Gleichrichterdiode 10 und der Freilaufdiode 11 ist mit der zweiten Induktivität 24 verbunden. Die Stromanstiegsbegrenzungsmittel tragen die Bezugszeichen 27 für den Bipolartransistor und 28 für den Basisvorwiderstand. In diesem Ausführungsbeispiel nach Fig. 3 wird ein Bipolartransistor 27 umgekehrter Polarität verwendet, und der Bipolartransistor 27 ist in den Gatestrompfad geschaltet. Die Funktionsweise dieser Ausführungsform ist im wesentlichen dieselbe wie diejenige nach Figur 2. Sie funktioniert wie folgt: Bei positiver Gate-Kathoden-Spannung teilt sich der Strom aus der zweiten Induktivität 24 in einen Basisstrom und einen Kollektorstrom des Bipolartransistors 27. Der Basisstrom schaltet den Bipolartransistor 27 durch. Somit wird die zweite Induktivität 24 direkt mit dem Gate des Abschaltthyristors 14 verbunden. Bei negativer Gate-Kathoden-Spannung beginnt der Bipolartransistor 27 zu regeln: Damit der Bipolartransistor 27 einen Kollektorstrom führen kann, muss sein Emitter um die Flussspannung, d.h. ca. 0.7V positiver sein als die Basis. Die in erster Näherung als Stromquelle zu betrachtende zweite Induktivität 24 arbeitet aber weiterhin als Gegenspannung. Die Kollektorspannung wird negativ, sobald der Kommutierungsvorgang, d.h. der Abschaltthyristors 14 dies erzwingt. Trotzdem fliesst der Strom aus der zweiten Induktivität 24 zum grossen Teil weiter über die Emitter-Kollektor-Strecke. Dieser Strom wird wirksam begrenzt, weil der Bipolartransistor 27 dies durch die Regelbedingung Uₑᵢₙ=U_{EB} + U_{R} verhindert. Uₑᵢₙ bezeichnet dabei die Spannung an der Induktivität, U_{EB} die Emitter-Basis-Spannung und U_{R} den Spannungsabfall am Basisvorwiderstand. Die Vorrichtung nach Fig. 2 mit dem npn- Bipolartransistor 26 anstelle des erläuterten pnp- Bipolartransistors 27 funktioniert analog.

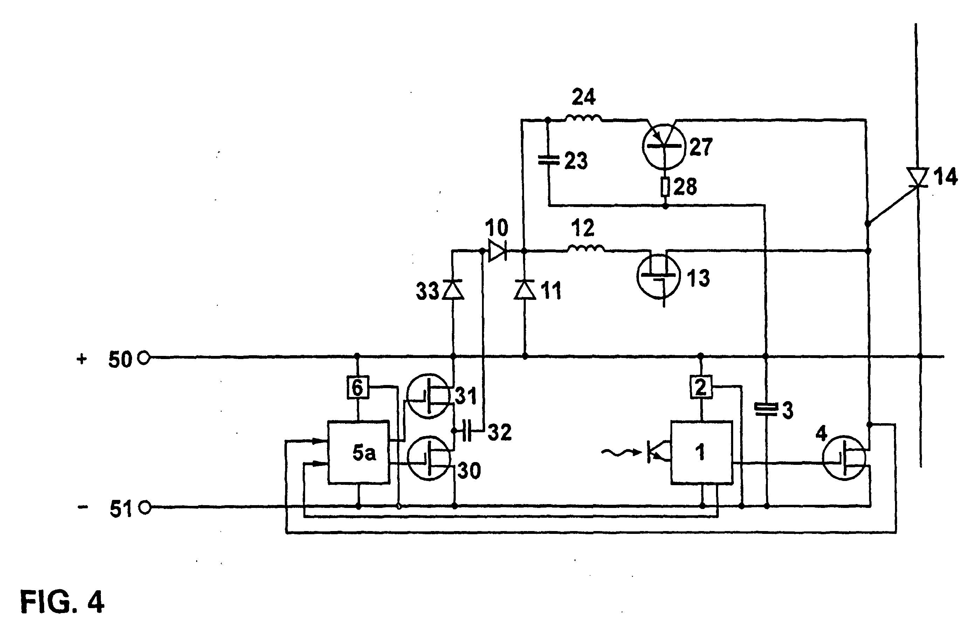

Anstelle einer induktiven Kopplung mit Hilfe eines Transistors 26, 27 ist auch eine kapazitive Kopplung mit Kondensatoren möglich. Fig. 4 zeigt ein entsprechendes Ausführungsbeispiel. Eine Einschaltlogik 5a steuert zwei zwischen den Anschlüssen 50 und 51 angeordnete Transistoren 31 und 30 an. Der Transistor 31 erzeugt einen positiven Spannungspuls, der Transistor 30 setzt zurück. Über einen Koppelkondensator 32 wird der erzeugte Spannungspuls an die Gleichrichterdiode 10 weitergegeben. Ausserdem ist eine Rückladediode 33 vorgesehen, die zwischen der Kathode des Abschaltthyristors 14 bzw. dem Plusanschluss 50 der Spannungsquelle und der Gleichrichterdiode 10 angeordnet ist. Im übrigen funktioniert die Schaltung nach Fig. 4 wie die bereits weiter oben beschriebene.

Fig. 6 zeigt nun eine Ausführungsform der Ansteuerschaltung zum Ein- und Ausschalten eines Abschaltthyristors 14 nach der Erfindung, bei der zur Erzeugung des Einschaltstromes bzw. Zündstromes vorteilhaft die Ausschaltschaltung zu Hilfe genommen wird. Die Logiken 1 und 5 sind der Übersichtlichkeit halber nicht mehr dargestellt. Die Ansteuerschaltung gemäss Fig. 6 umfasst ebenfalls die Ausschaltschaltung und die Einschaltschaltung, wobei die Ausschaltschaltung auch den kapazitiven Energiespeicher 3 umfasst, welcher an den Kathodenanschluss und über den ersten Schalter 4 an den Gateanschluss des Abschaltthyristors 14 angeschlossen ist und aus dem mittels des ersten Schalters 4 Energie zur Erzeugung des Ausschaltstromes entnehmbar ist. Die Einschaltschaltung ist zum Erzeugen des Einschaltstromes und des einen eingeschalteten Zustand des Abschaltthyristors 14 aufrechterhaltenden Haltestromes ausgebildet. Die Einschaltschaltung weist einen elektrischen Energiespeicher 24 auf, der Spannungspulse in den Einschaltstrom und den Haltestrom umwandelt. Vorzugsweise umfasst der elektrische Energiespeicher 24 der Einschaltschaltung gemäss Fig. 6 eine Induktivität 24. Ferner weist die Einschaltschaltung den zweiten Schalter 7 auf. Erfindungsgemäss umfasst die Einschaltschaltung eine Speicherinduktivität 34, mittels welcher zur Erzeugung des Haltestromes dem kapazitiven Energiespeicher 3 Spannungspulse entnehmbar und dem elektrischen Energiespeicher 24 der Einschaltschaltung zuführbar sind, wobei die Einschaltschaltung zur Erzeugung des Einschaltstromes eine zuschaltbare Zünd induktivität 35 umfasst. Vorzugsweise ist eine Reihenschaltung eines Bipolartransistors 27 mit einem Basisvorwiderstand 28 zwischen das Gate und die Kathode des Abschaltthyristors 14 geschaltet, wobei der Bipolartransistor 27 mit dem Gate des Abschaltthyristors 14 und mit der Induktivität 24 der Einschaltschaltung verbunden ist. Der Bipolartransistor 27 ist somit in den Gatestrompfad geschaltet. Die Reihenschaltung des Bipolartransistors 27 mit dem Basisvorwiderstand 28 dient der Begrenzung des Haltestromes. Diese Reihenschaltung verhindern zuverlässig, dass der Haltestrom bei einer negativen Gate-Kathoden-Spannung ungehindert ansteigen kann. Insbesondere ist die Funktionsweise der Reihenschaltung der Bipolartransistors 27 mit dem Basisvorwiderstand 28 analog der Reihenschaltung gemäss Fig. 2, Fig. 3 bzw. Fig. 4.

Die Schaltung nach Fig. 6 funktioniert wie folgt: Ein Ladetransistor 36 verbindet eine zuschaltbare Zündinduktivität 35 mit dem Plusanschluss 50 bevor der erste Schalter 4 gesperrt wird. Infolgedessen baut sich in der Zündinduktivität 35 ein Strom auf, der nach Sperren des ersten Schalters 4 direkt auf das Gate kommutiert und so den geforderten Zündimpuls bildet. Die Zündinduktivität 35 kann so gewählt werden, dass sich der Strom in ca. 5µs bis 10µs abbaut. Danach blockiert die der Zündinduktivität 35 vorgeschaltete Ladediode 37, und der Ladetransistor 36 kann wieder gesperrt werden. Wenn der Ladetransistor 36 vor Abklingen des Stromes gesperrt wird, so kann die Restenergie über die Freilaufdiode 38 in den kapazitiven Energiespeicher 3 zurückgegeben werden. Auf diese Weise wird ein besonders kurzer und dennoch voll wirksamer Zündimpuls erzeugt. Der Teil der Einschaltschaltung, der für die Erzeugung des Haltestromes ausgebildet ist, kann wie bereits beschrieben aufgebaut sein, oder die benötigte Energie kann aus dem kapazitiven Energiespeicher 3 mittels der Speicherinduktivität 34 und der Gleichrichterdiode 21 durch Taktung des zweiten Schalters 7 an den elektrischen Energiespeicher 24 übergeben werden. Zum Ausschalten des Abschaltthyristors 14 wird durch Betätigen des ersten Schalters 4 aus dem Gate ein Strom gezogen. Die erfindungsgemässe Ansteuerschaltung kommt damit mit wenig Bauteilen und einem kleinen Platzbedarf, vor allem aber ohne Transformatoren, aus. Weiterhin ist die erfindungsgemässe Ansteuerschaltung mit einem geringem Energiebedarf realisierbar und insbesondere für die Anwendung des harten Ansteuerverfahrens geeignet.

In der vorstehenden Beschreibung wurden verschiedene Varianten der Energiekopplung und Speisung angegeben, die zwar nur anhand einzelner Figuren erläutert wurden, aber selbstverständlich fast beliebig miteinander kombinierbar sind, je nachdem, wo schaltungstechnisch ein Schwergewicht gebildet werden soll.

Die erfindungsgemässe Ansteuerschaltung und das zugrunde liegende Ansteuerverfahren ermöglichen eine Reduktion der Wiederholfrequenz f1 oder der Breite der Spannungspulse für den Haltestrom, sobald eine negative Gate-Kathoden-Spannung am Abschaltthyristor 14 auftritt. In der Folge wird der auftretende Verlust im Bipolartransistor der Stromanstiegsbegrenzungsmittel insbesondere bei Abschaltthyristoren höchster Leistung, d.h. solchen mit einem hohen Bedarf an Haltestrom (> 1 A), reduziert. Die Wiederholfrequenz bzw. die Pulsbreite kann nach Wiederherstellen einer positiven Spannung zwischen Gate und Kathode des Abschaltthyristors 14 wieder erhöht werden. Dadurch erreicht man wieder einen höheren Gatestrom, so dass ein lückenloses Wiederaufkommutieren des Abschaltthyristors 14 sichergestellt wird. Ein Nachzündimpuls in der bisher üblichen Form ist dadurch überflüssig. Damit verschwindet die Gefahr, dass der Nachzündimpuls zum falschen Zeitpunkt auftritt und auch alle übrigen mit der genauen Detektion des korrekten Zeitpunktes des Nachzündens verbundenen Probleme. Ausserdem kann die EMV-Immunität der Anordnung auf diese Weise erhöht werden. Ganz allgemein kann der Gatestrom durch eine Beeinflussung der Wiederholfrequenz oder der Pulsbreite der Spannungspulse eingestellt werden.

Insgesamt ergibt sich mit der Ansteuerschaltung ein kompakter, robuster und niederinduktiver Aufbau, der insbesondere für hart angesteuerte Abschaltthyristoren 14 grosse Vorteile aufweist. Es wird möglich, die Ansteuereinheit in unmittelbarer Nähe der Abschaltthyristoren 14 aufzubauen und damit einen äusserst kompakten Stromrichter herzustellen. Der Wirkungsgrad der Anordnung ist sehr hoch. Die Ansteuereinheit kann wie in der eingangs erwähnten DE 197 08 873 A1 aufgebaut werden. Die dort angegebene Anordnung ist speziell für das Auswechseln defekter Ansteuereinheiten von grossem Vorteil.

### Bezugszeichenliste

- 1: Ausschaltlogik
- 2: Längsregler
- 3: kapazitiver Energiespeicher, Ausschaltkondensatorbank
- 4: erste Schalter
- 5, 5a: Einschaltlogik
- 6: Längsregler
- 7: zweite Schalter
- 8: Primärwicklung des Transformators
- 9: Sekundärwicklung des Transformators
- 10: Gleichrichterdiode
- 11: Freilaufdiode
- 12: Speicherinduktivität
- 13: dritter Schalter
- 14: Abschaltthyristor
- 20: zweite Sekundärwicklung des Transformators
- 21: Gleichrichterdiode
- 22: Freilaufdiode
- 23: Kapazität
- 24: Induktivität, elektrischer Energiespeicher
- 25: Basiswiderstand
- 26: Bipolartransistor
- 27: Bipolartransistor
- 28: Basiswiderstand
- 30: Transistor
- 31: Transistor
- 32: Koppelkondensator
- 33: Rückladediode
- 34: Speicherinduktivität
- 35: Zündinduktivität
- 36: Ladetransistor
- 37: Ladediode
- 38: Freilaufdiode
- 50: Plusanschluss
- 51: Minusanschluss

- U_{EB}: Emitter-Basisspannung
- U_{R}: Spannung am Basiswiderstand 28
- V_{T}: Spannung an der Freilaufdiode 22
- I_{G}: Gatestrom

## Patentansprüche

1. Ansteuerschaltung zum Ein- und Ausschalten eines Abschaltthyristors (14), wobei die Ansteuerschaltung eine Ausschaltschaltung und eine Einschaltschaltung umfasst, die Ausschaltschaltung einen kapazitiven Energiespeicher (3) umfasst, welcher an den Kathodenanschluss und über einen ersten Schalter (4) an den Gateanschluss des Abschaltthyristors (14) angeschlossen ist und aus dem mittels des ersten Schalters (4) Energie zur Erzeugung eines Ausschaltstromes entnehmbar ist,
die Einschaltschaltung zum Erzeugen eines Einschaltstromes und eines einen eingeschalteten Zustand des Abschaltthyristors (14) aufrechterhaltenden Haltestromes ausgebildet ist,
die Einschaltschaltung einen elektrischen Energiespeicher (24) umfasst, der Spannungspulse in den Einschaltstrom und den Haltestrom umwandelt, und
die Einschaltschaltung einen zweiten Schalter (7) aufweist,
**dadurch gekennzeichnet,**
**dass** die Einschaltschaltung eine Speicherinduktivität (34) umfasst, mittels welcher zur Erzeugung des Haltestromes dem kapazitiven Energiespeicher (3) Spannungspulse entnehmbar und dem elektrischen Energiespeicher (24) der Einschaltschaltung zuführbar sind, und
**dass** die Einschaltschaltung zur Erzeugung des Einschaltstromes eine zuschaltbare Zündinduktivität (35) umfasst.

2. Ansteuerschaltung nach Anspruch 1, **dadurch gekennzeichnet, dass** der elektrische Energiespeicher (24) der Einschaltschaltung eine Induktivität (24) umfasst.

3. Ansteuerschaltung nach Anspruch 2, **dadurch gekennzeichnet, dass** ein Bipolartransistor (27) mit einem Basisvorwiderstand (28) zwischen das Gate und die Kathode des Abschaltthyristors (14) geschaltet ist.

4. Ansteuerschaltung nach Anspruch 3, **dadurch gekennzeichnet, dass** die kollektor-Emitter-Strecke des Bipolartransistors (27) zwischen dem Gate des Abschaltthyristors (14) und der Induktivität (24) der Einschaltschaltung liegt.

## Claims

1. Driving circuit for turning a gate turn-off thyristor (14) on and off, the driving circuit comprising a turn-off circuit and a turn-on circuit, the turn-off circuit comprising a capacitive energy store (3) which is connected to the cathode terminal and, via a first switch (4), to the gate terminal of the gate turn-off thyristor (14), and from which energy can be drawn to generate a turn-off current by means of the first switch (4),
the turn-on circuit being designed to generate a.turn-on current and a holding current which maintains a turned-on state of the gate turn-off thyristor (14),
the turn-on circuit comprising an electrical energy store (24) which converts voltage pulses into the turn-on current and the holding current, and
the turn-on circuit having a second switch (7), **characterized in that** the turn-on circuit comprises a storage inductor (34) by means of which voltage pulses can be drawn from the capacitive energy store (3) to generate the holding current and can be fed to the electrical energy store (24) of the turn-on circuit, and
**in that** the turn-on circuit comprises a connectable trigger inductor (35) for generating the turn-on current.

2. Driving circuit according to Claim 1, **characterized in that** the electrical energy store (24) of the turn-on circuit comprises an inductor (24).

3. Driving circuit according to Claim 2, **characterized in that** a bipolar transistor (27) is connected to a base resistor (28) between the gate and the cathode of the gate turn-off thyristor (14).

4. Driving circuit according to Claim 3, **characterized in that** the collector-emitter path of the bipolar transistor (27) is situated between the gate of the gate turn-off thyristor (14) and the inductor (24) of the turn-on circuit.

## Revendications

1. Circuit de commande pour allumer et éteindre un thyristor à commande d'ouverture (14), le circuit de commande comprenant un circuit d'extinction et un circuit d'allumage, le circuit d'extinction comprenant un accumulateur d'énergie capacitif (3) qui est raccordé à la borne de cathode et, par le biais d'un premier commutateur (4), à la borne de gâchette du thyristor à commande d'ouverture (14) et duquel peut être prélevée au moyen du premier commutateur (4) de l'énergie pour générer un courant d'extinction, le circuit d'allumage étant configuré pour générer un courant d'allumage et un courant de maintien qui maintient le thyristor à commande d'ouverture (14) dans l'état passant, le circuit d'allumage comprenant un accumulateur d'énergie électrique (24) qui convertit des impulsions de tension en le courant d'allumage et le courant de maintien et le circuit d'allumage présentant un deuxième commutateur (7), **caractérisé en ce que** le circuit d'allumage comprend une inductance de stockage (34) au moyen de laquelle des impulsions de tension peuvent être prélevées de l'accumulateur d'énergie capacitif (3) pour générer le courant de maintien et peuvent être acheminées à l'accumulateur d'énergie électrique (24) du circuit d'allumage et **en ce que** le circuit d'allumage comprend un inductance d'amorçage commutable (35) pour générer le courant d'allumage.

2. Circuit de commande selon la revendication 1, **caractérisé en ce que** l'accumulateur d'énergie électrique (24) du circuit d'allumage comprend une inductance (24).

3. Circuit de commande selon la revendication 2, **caractérisé en ce qu'**un transistor bipolaire (27) est branché entre la gâchette et la cathode du thyristor à commande d'ouverture (14) avec une résistance série de base (28).

4. Circuit de commande selon la revendication 3, **caractérisé en ce que** la section collecteur-émetteur du transistor bipolaire (27) se trouve entre la gâchette du thyristor à commande d'ouverture (14) et l'inductance (24) du circuit d'allumage.
